# EUROPEAN PATENT APPLICATION

(11) **EP 4 443 474 A1**
(43) Date of publication of application: **09.10.2024**
(21) Application number: 22936120.9
(22) Date of filing: 07.04.2022

(54) **DISPLAY SUBSTRATE AND MANUFACTURING METHOD THEREOF, AND DISPLAY DEVICE**

(71) Applicant: Boe Technology Group Co., Ltd., Beijing 100015 (CN); Hefei Xinsheng Optoelectronics Technology Co., Ltd., Hefei, Anhui 230012 (CN)
(72) Inventor: LIU, Ning, Beijing 100176 (CN); XU, Chunjie, Beijing 100176 (CN); GUI, Xuehai, Beijing 100176 (CN); ZHOU, Bin, Beijing 100176 (CN); YAN, Liangchen, Beijing 100176 (CN)
(74) Representative: AWA Sweden AB
(86) International application number: PCT/CN2022/085506
(87) International publication number: WO 2023/193173

(57) **Abstract**

A display substrate (100) and a method of manufacturing the same, and a display device (200) are provided. The display substrate (100) includes: a base substrate (10) and a plurality of pixel units (PX) each includes a plurality of sub-pixels, and each sub-pixel includes a light emitting element and a pixel driving circuit; a functional layer (20) arranged on a side of the base substrate (10); a light-shielding layer (30) arranged on a side of the functional layer (20) away from the base substrate (10), wherein the light-shielding layer (30) is electrically connected to the functional layer (20); a buffer layer (34) arranged on a side of the light-shielding layer (30) away from the base substrate (10) and covering the functional layer (20) and the light-shielding layer (30); an active layer (40) arranged on a side of the buffer layer (34) away from the base substrate (10); a gate electrode layer (50) arranged on a side of the active layer (40) away from the base substrate (10); a first via hole (60) penetrating the buffer layer (34); and a signal line arranged on a side of the buffer layer (34) away from the base substrate (10). The functional layer (20) of the pixel driving circuit is electrically connected to the signal line through the first via hole (60). A projection of the light-shielding layer (30) on the base substrate (10) and a projection of the functional layer (20) on the base substrate (10) form an overlap region, and a projection of the first via hole (60) on the base substrate (10) is located in the overlap region.

## Description

### TECHNICAL FIELD

The present disclosure relates to a field of display technology, and in particular to a display substrate and a method of manufacturing the same, and a display device.

### BACKGROUND

In a structure of a top gate AMOLED product, since a top gate TFT has a characteristic of short channel, an on-state current of the top gate type TFT may be effectively increased, which may significantly improve a display effect and effectively reduce a power consumption. In addition, an area of an overlap region of a gate electrode and a source/drain electrode of the top gate type TFT is small, thus a parasitic capacitance generated is small, and a possibility of GDS (a dark spot gradually grows up after forming until an entire display surface becomes invalid) and other defects is also reduced. Since the above-mentioned remarkable advantages, the top gate type TFT has attracted more and more attention. However, in a design process of the product, since an etching medium has different etching rates on different layers in a stacked structure, and lengths of etched via holes in different layers are different, an etching time and an etching process are difficult to control, and some layers are prone to be excessively-etched during the etching process, which seriously affects a transmission of an electrical signal and an overlap, reduces a production yield, or reduces a display quality of the product.

It should be noted that the information disclosed in the background section is only used to strengthen an understanding of the background of the present disclosure, and therefore, the above information may include information that does not constitute the prior art known to those skilled in the art.

### SUMMARY

In an aspect, a display substrate is provided, including but not limited to: a base substrate and a plurality of pixel units arranged on the base substrate, wherein each pixel unit includes a plurality of sub-pixels, and each sub-pixel includes a light emitting element and a pixel driving circuit for driving the light emitting element; wherein the pixel driving circuit includes: a functional layer arranged on a side of the base substrate; a light-shielding layer arranged on a side of the functional layer away from the base substrate, wherein the light-shielding layer is electrically connected to the functional layer; a buffer layer arranged on a side of the light-shielding layer away from the base substrate and covering the functional layer and the light-shielding layer; an active layer arranged on a side of the buffer layer away from the base substrate; a gate electrode layer arranged on a side of the active layer away from the base substrate; a first via hole penetrating the buffer layer; and a signal line arranged on a side of the buffer layer away from the base substrate; wherein the functional layer of the pixel driving circuit of each sub-pixel is electrically connected to the signal line at least through the first via hole; and wherein a projection of the light-shielding layer on the base substrate and a projection of the functional layer on the base substrate form an overlap region, and a projection of the first via hole on the base substrate is located in the overlap region.

In some exemplary embodiments of the present disclosure, a thickness of the light-shielding layer is greater than a thickness of the functional layer.

In some exemplary embodiments of the present disclosure, the thickness of the light-shielding layer ranges from 1000 Å to 1500 Å, and the thickness of the functional layer ranges from 400 Å to 1000 Å.

In some exemplary embodiments of the present disclosure, an etching rate of an etching medium on the functional layer is less than an etching rate of the etching medium on the light-shielding layer.

In some exemplary embodiments of the present disclosure, the pixel driving circuit includes a storage capacitance; wherein a part of the functional layer forms a first electrode of the storage capacitance, and a part of the active layer forms a second electrode of the storage capacitance; and wherein the light-shielding layer includes a first light-shielding part, an orthographic projection of the first electrode on the base substrate overlaps with an orthographic projection of the first light-shielding part on the base substrate to form a first overlap region, and an area of the orthographic projection of the first electrode on the base substrate is greater than an area of the orthographic projection of the first light-shielding part on the base substrate.

In some exemplary embodiments of the present disclosure, an orthographic projection of the first via hole on the base substrate is located in the first overlap region.

In some exemplary embodiments of the present disclosure, the signal line includes a sensing signal line, and the pixel driving circuit of each sub-pixel at least includes a sensing transistor; wherein first electrodes or second electrodes of all sensing transistors of each pixel unit are electrically connected to the sensing signal line at least through the first via hole; wherein a part of the functional layer forms a first functional region of the sensing transistor; and wherein an orthographic projection of the light-shielding layer on the base substrate overlaps with an orthographic projection of the first functional region on the base substrate to form a second overlap region.

In some exemplary embodiments of the present disclosure, the orthographic projection of the first via hole on the base substrate is located in the second overlap region.

In some exemplary embodiments of the present disclosure, the first electrode or the second electrode of the sensing transistor is electrically connected to the first functional region through the first via hole.

In some exemplary embodiments of the present disclosure, the first functional region includes a first functional sub-region and a second functional sub-region; and wherein a part of the light-shielding layer forms a first conductive connection part, the first functional sub-region is electrically connected to the first electrode, and the first conductive connection part is configured to electrically connect the second functional sub-regions of the sensing transistors of different sub-pixels.

In some exemplary embodiments of the present disclosure, the pixel driving circuit of each sub-pixel further includes a driving transistor; wherein a first electrode or a second electrode of each driving transistor is electrically connected to the first electrode through the first via hole; wherein the signal line further includes a driving voltage signal line; wherein a part of the functional layer forms a second functional region electrically connected to the first electrode or the second electrode of the driving transistor; and wherein a part of the light-shielding layer forms a second conductive connection part, and the second conductive connection part is configured to electrically connect the second functional region of at least one sub-pixel in one and the same pixel unit with the driving voltage signal line.

In some exemplary embodiments of the present disclosure, an orthographic projection of the second functional region on the base substrate and an orthographic projection of the second conductive connection part on the base substrate coincides to form a third overlap region.

In some exemplary embodiments of the present disclosure, the orthographic projection of the first via hole on the base substrate is located in the third overlap region.

In some exemplary embodiments of the present disclosure, in a direction perpendicular to a length of the first conductive connection part, a width of the first conductive connection part located in the second overlap region is greater than a width of the first conductive connection part between adjacent sub-pixels.

In some exemplary embodiments of the present disclosure, in the second overlap region and the third overlap region, the orthographic projection of the functional layer on the base substrate is located within the orthographic projection of the light-shielding layer on the base substrate.

In some exemplary embodiments of the present disclosure, a part of the functional layer forms a third conductive connection part, and the third conductive connection part is configured to electrically connect the first electrode with the first functional sub-region of the sensing transistor. A width of the third conductive connection part in a length direction of the third conductive connection part is greater than a width of the first conductive connection part in a length direction of the first conductive connection part, and the width of the third conductive connection part in the length direction of the third conductive connection part is greater than a width of the second conductive connection part in a length direction of the second conductive connection part.

In some exemplary embodiments of the present disclosure, the second overlap region includes a first overlap sub-region and a second overlap sub-region, an area of the first overlap sub-region is greater than an area of the second overlap sub-region, and the orthographic projection of the first via hole on the base substrate is located in the first overlap sub-region.

In some exemplary embodiments of the present disclosure, the second overlap region includes a first electrode overlap region located at the first electrode of the sensing transistor, and a second electrode overlap region located at the second electrode of the sensing transistor; and wherein the first electrode overlap region and the second electrode overlap region have a proportionally same shape.

In some exemplary embodiments of the present disclosure, the light-shielding layer includes an opaque metal conductive material; and wherein the functional layer includes a light-transmitting metal oxide material.

In another aspect of the present disclosure, a method of manufacturing a display substrate is provided, including: forming a base substrate; forming a plurality of pixel units on the base substrate, wherein each pixel unit includes a plurality of sub-pixels, and the forming a plurality of pixel units includes forming, at each sub-pixel, a light emitting element and a pixel driving circuit for driving the light emitting element; wherein the forming a pixel driving circuit includes: forming a functional layer on a side of the base substrate; forming a light-shielding layer on a side of the functional layer away from the base substrate, wherein the light-shielding layer is electrically connected to the functional layer; forming a buffer layer on a side of the light-shielding layer away from the base substrate, wherein the buffer layer covers the functional layer and the light-shielding layer; forming an active layer on a side of the buffer layer away from the base substrate; forming a gate electrode layer on a side of the active layer away from the base substrate; forming a first via hole penetrating the buffer layer; and forming a signal line on a side of the buffer layer away from the base substrate; wherein the functional layer of the pixel driving circuit of each sub-pixel is electrically connected to the signal line at least through the first via hole; and wherein a projection of the light-shielding layer on the base substrate and a projection of the functional layer on the base substrate form an overlap region, and a projection of the first via hole on the base substrate is located in the overlap region.

In yet another aspect, a display device is provided, wherein the display device includes the display substrate described above.

### BRIEF DESCRIPTION OF THE DRAWINGS

Other objectives and advantages of the present disclosure will become apparent through the following description of the present disclosure with reference to the accompanying drawings, which may facilitate a comprehensive understanding of the present disclosure.
FIG. 1 is a schematic plan view of a display substrate according to embodiments of the present disclosure.
FIG. 2A is a partial plan view of a pixel driving circuit of a display substrate according to embodiments of the present disclosure, which schematically shows a plan view of a sub-pixel driving circuit included in the display substrate.
FIG. 2B is a sectional view taken along line MM' in FIG. 2A.
FIG. 3 is a partial plan view of a display substrate according to some other embodiments of the present disclosure, which schematically shows a plan view of a plurality of sub-pixel driving circuits included in the display substrate.
FIG. 4 is an equivalent circuit diagram of a pixel driving circuit of a single sub-pixel of the display substrate in FIG. 2A and FIG. 3.
FIG. 5 to FIG. 11 are plan views of different film layers of the pixel driving circuit shown in FIG. 2A, respectively.
FIG. 12 to FIG. 18 are plan views of different film layers of the pixel driving circuit shown in FIG. 3, respectively.
FIG. 19 is a partial enlarged view of a sensing transistor of a display substrate according to some other embodiments of the present disclosure.
FIG. 20 is a schematic diagram of a display device according to embodiments of the present disclosure.

It should be noted that, for the sake of clarity, dimensions of layers, structures or regions in the accompanying drawings used to describe embodiments of the present disclosure may be exaggerated or reduced, i.e., the accompanying drawings are not drawn to actual scale.

### DETAILED DESCRIPTION OF EMBODIMENTS

Technical solutions of the present disclosure will be further described in detail below through embodiments in combination with the accompanying drawings. In the description, the same or similar reference numerals denote the same or similar parts. The following description of embodiments of the present disclosure with reference to the accompanying drawings is intended to explain the general inventive concept of the present disclosure, and should not be construed limiting the present disclosure.

In addition, in the following detailed description, for purposes of explanation, numerous specific details are set forth in order to provide a comprehensive understanding of embodiments of the present disclosure. It is obvious, however, that one or more embodiments may be implemented without these specific details.

It should be understood that, although the terms first, second, etc., may be used here to describe various elements, these elements should not be limited by these terms. These terms are only used to distinguish one element from another. For example, without departing from the scope of exemplary embodiments, a first element could be named as a second element, and, similarly, a second element could be named as a first element. As used here, a term "and/or" includes any and all combinations of one or more of related items listed.

It should be understood that when an element or layer is described as being "formed on" another element or layer, the element or layer may be directly or indirectly formed on the another element or layer. That is, for example, there may be an intervening element or an intervening layer. On the contrary, when an element or layer is described as being "directly formed on" another element or layer, there is no intervening element or intervening layer. Other terms used to describe a relationship between elements or layers should be interpreted in a similar way, such as, "between ... and" versus "directly between ... and", "adjacent" versus "directly adjacent", etc.

Herein, directional expressions "first direction" and "second direction" are used to describe different directions along a pixel region. For example, a longitudinal direction and a lateral direction of the pixel region. It should be understood that such expression is only an exemplary description, rather than a limitation on the present disclosure.

Herein, unless otherwise specifically stated, the expression "on a same layer" generally means that a first part and a second part may use a same material and may be formed by a same patterning process. The expression "A and B are connected as a whole" means that a component A and a component B are formed as a whole, that is, the part A and the part B generally contain a same material and form a structurally continuous integral component.

Transistors used in embodiments of the present disclosure may be thin film transistors, field effect transistors, or other devices having a same characteristic. Since a source electrode and a drain electrode of the thin film transistor used here are symmetrical, the source electrode and the drain electrode may be interchanged. In the following example, the description is mainly based on a case of a P-type thin film transistor used as a driving transistor. Other transistors have a same or different type from the driving transistor according to a circuit design. Similarly, in other embodiments, the driving transistor may also be shown as an N-type thin film transistor.

In embodiments of the present disclosure, a term "opaque metal conductive material" may be expressed as that light may not pass through the material, and the material is a material having a conductive property and contains a metal. A term "light-transmitting metal oxide material" may be expressed as that light may pass through the material, and the material is a metal oxide.

Some exemplary embodiments of the present disclosure provide a display substrate, and the display substrate includes: a base substrate and a plurality of pixel units arranged on the base substrate, wherein each pixel unit includes a plurality of sub-pixels, and each sub-pixel includes a light emitting element and a pixel driving circuit for driving the light emitting element; the pixel driving circuit includes: a functional layer arranged on a side of the base substrate; a light-shielding layer arranged on a side of the functional layer away from the base substrate, wherein the light-shielding layer is electrically connected to the functional layer; a buffer layer arranged on a side of the light-shielding layer away from the base substrate and covering the functional layer and the light-shielding layer; an active layer arranged on a side of the buffer layer away from the base substrate; a gate electrode layer arranged on a side of the active layer away from the base substrate; an interlayer dielectric layer arranged on a side of the gate electrode layer away from the base substrate and covering the active layer and the gate electrode layer; a first via hole penetrating the interlayer dielectric layer and the buffer layer; a signal line arranged on a side of the interlayer dielectric layer away from the base substrate; wherein the functional layer of the pixel driving circuit of each sub-pixel is electrically connected to the signal line at least through the first via hole; a projection of the light-shielding layer on the base substrate and a projection of the functional layer on the base substrate form an overlap region, and a projection of the first via hole on the base substrate is located in the overlap region. Through such arrangement, the formed display substrate may be guaranteed to have a good electrical signal transmission characteristic and a high yield.

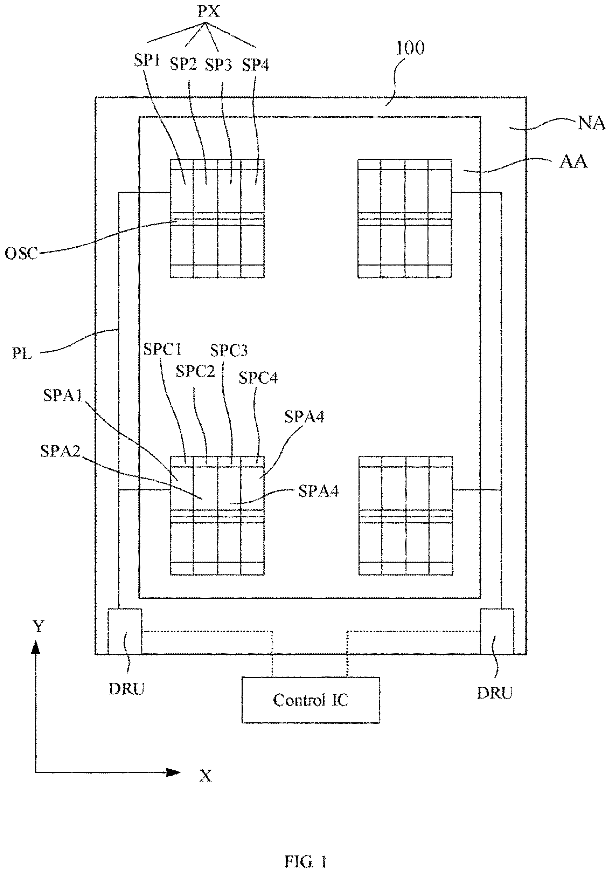

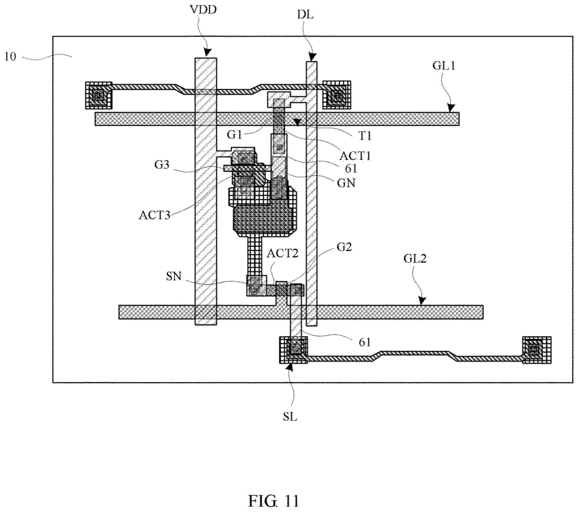

The following is a detailed description of a display substrate according to embodiments of the present disclosure in combination with FIG. 1 to FIG. 19.

FIG. 1 is a schematic plan view of a display substrate according to embodiments of the present disclosure. As shown in FIG. 1, the display substrate according to embodiments of the present disclosure may include a base substrate 100, a pixel unit PX arranged on the base substrate 100, a driving unit DRU arranged on the base substrate 100, and a wire PL electrically connecting the pixel unit PX with the driving unit DRU. The driving unit DRU is used to drive the pixel unit PX.

The display substrate may include a display region AA and a non-display region NA. The display region AA may be a region provided with a pixel unit PX for displaying image. Each pixel unit PX will be described later. The non-display region NA is a region where the pixel unit PX is not provided, that is, a region where an image is not displayed. The driving unit DRU used to drive the pixel unit PX and some wires PL connecting the pixel unit PX with the driving unit DRU may be provided in the non-display region NA. The non-display region NA corresponds to a bezel in a final display device, and a width of the border may be determined according to a width of the non-display region NA.

The display region AA may have various shapes. For example, the display region AA may be provided in various shapes such as a closed polygon (such as a rectangle) including straight sides, a circle, an ellipse, etc., including a curved side, and a semicircle and a semi-ellipse, etc., including a straight side and a curved side. In embodiments of the present disclosure, the display region AA is provided as a region with a quadrilateral shape including straight sides. It should be understood that this is only an exemplary embodiment of the present disclosure, rather than a limitation on the present disclosure.

The non-display region NA may be arranged on at least one side of the display region AA. In embodiments of the present disclosure, the non-display region NA may surround a periphery of the display region AA. In embodiments of the present disclosure, the non-display region NA may include a lateral part extending in a first direction X and a longitudinal part extending in a second direction Y

The pixel unit PX is arranged in the display region AA. The pixel unit PX is a smallest unit for displaying image, and a plurality of pixel units may be provided. For example, the pixel unit PX may include a light emitting device that emits white light and/or color light.

A plurality of pixel units PX may be provided to be arranged in a matrix along a row extending in the first direction X and a column extending in the second direction Y However, embodiments of the present disclosure do not specifically limit an arrangement form of the pixel units PX, and the pixel units PX may be arranged in various forms. For example, the pixel units PX may be arranged so that a direction inclined relative to the first direction X and the second direction Y becomes a column direction of the pixel units PX, and a direction intersecting with the column direction becomes a row direction of the pixel units PX.

A pixel unit PX may include a plurality of sub-pixels. For example, a pixel unit PX may include four sub-pixels, that is, a first sub-pixel SP1, a second sub-pixel SP2, a third sub-pixel SP3, and a fourth sub-pixel SP4. For example, the first sub-pixel SP1 may be a red sub-pixel, the second sub-pixel SP2 may be a green sub-pixel, the third sub-pixel SP3 may be a blue sub-pixel, and the fourth sub-pixel SP4 may be a white sub-pixel.

Each sub-pixel may include a light emitting element and a pixel driving circuit for driving the light emitting element. For example, the first sub-pixel SP1 may include a first light emitting element located in a first light emitting region SPA1 and a first pixel driving circuit SPC1 for driving the first light emitting element, and the first light emitting element may emit red light; the second sub-pixel SP2 may include a second light emitting element located in a second light emitting region SPA2 and a second pixel driving circuit SPC2 for driving the second light emitting element, and the second light emitting element may emit green light; the third sub-pixel SP3 may include a third light emitting element located in a third light emitting region SPA3 and a third pixel driving circuit SPC3 for driving the third light emitting element, and the third light emitting element may emit blue light; the fourth sub-pixel SP4 may include a fourth light emitting element located in a fourth light emitting region SPA4 and a fourth pixel driving circuit SPC4 for driving the fourth light emitting element, and the fourth light emitting element may emit white light.

The light emitting region of the sub-pixel may be a region where the light emitting element of the sub-pixel is located. For example, in an OLED display panel, the light emitting element of the sub-pixel may include a first electrode (such as an anode), a luminescent material layer, and a second electrode (such as a cathode) that are stacked. In this way, the light emitting region of the sub-pixel may be a region corresponding to a part of the luminescent material layer sandwiched between the anode and the cathode.

The sub-pixel further includes a non-light-emitting region. For example, the pixel driving circuit of the sub-pixel is located in the non-light-emitting region of the sub-pixel. A ratio of an area of the light emitting region of each sub-pixel to an overall area (a sum of an area of the light emitting region and an area of the non-light-emitting region) of the sub-pixel determines an opening rate of the sub-pixel.

In the embodiment shown in FIG. 1, the sub-pixel SP1, the sub-pixel SP2, the sub-pixel SP3 and the sub-pixel SP4 are arranged side by side.

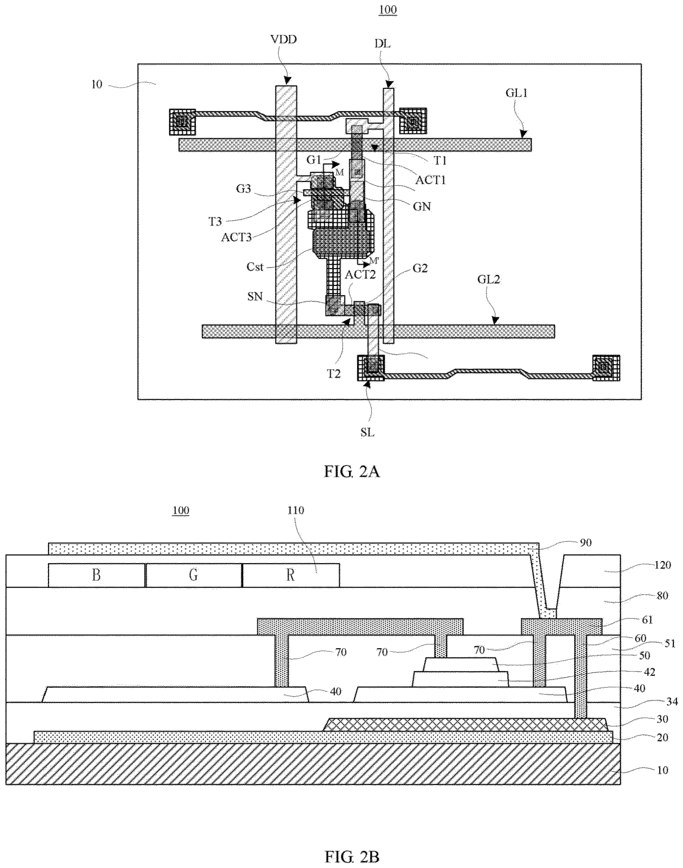

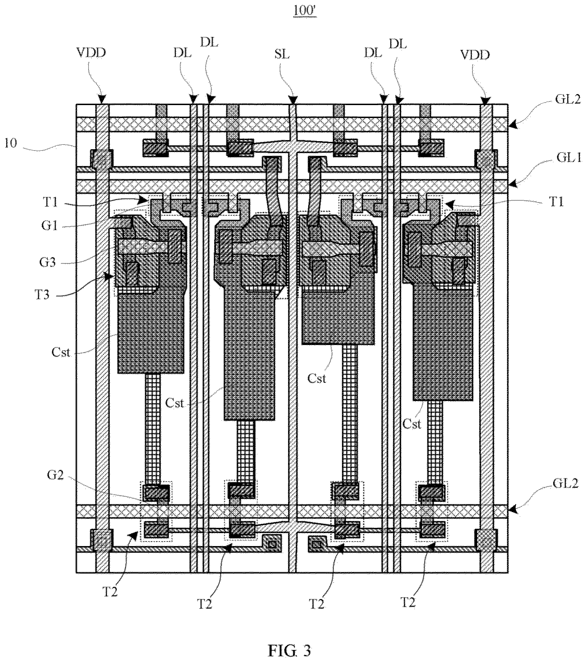

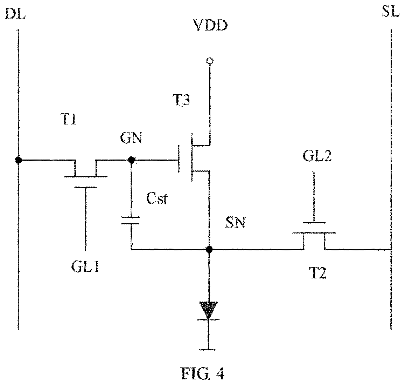

FIG. 2A is a partial plan view of a pixel driving circuit of the display substrate according to embodiments of the present disclosure, which schematically shows a plan view of a sub-pixel driving circuit included in the display substrate. FIG. 2B is a sectional view taken along line MM' in FIG. 2A. FIG. 3 is a partial plan view of a display substrate according to some other embodiments of the present disclosure, which schematically shows a plan view of a plurality of sub-pixel driving circuits included in the display substrate. FIG. 4 is an equivalent circuit diagram of a pixel driving circuit of a single sub-pixel of the display substrate in FIG. 2A and FIG. 3.

As shown in FIG. 2A, FIG. 2A schematically shows a partial plan view of a pixel driving circuit of a single sub-pixel. As shown in FIG. 3, FIG. 3 schematically shows a partial plan view of pixel driving circuits of a plurality of sub-pixels within a pixel unit. As shown in FIG. 2A to FIG. 4, a pixel driving circuit of each sub-pixel includes a switching transistor T1, a sensing transistor T2, a driving transistor T3 and a storage capacitance Cst. As shown in FIG. 4, a first electrode of the switching transistor T1 is connected to a data line DL to which a data signal of the pixel driving circuit is input, so as to receive the data signal of the pixel driving circuit. A gate electrode layer forms a gate electrode of a transistor, and a gate electrode of the switching transistor T1 is connected to a first scanning signal GL1. A second electrode of the switching transistor T1 is connected to a gate electrode of the driving transistor T3. The switching transistor T1 is used to control a writing of a voltage signal from the data line DL to the pixel driving circuit.

It should be noted that each transistor may include an active layer, a gate electrode, a first electrode (such as a source electrode), and a second electrode (such as a drain electrode). For example, the switching transistor T1 includes a first gate electrode G1 and a first active layer ACT1. The sensing transistor T2 includes a second gate electrode G2 and a second active layer ACT2. The driving transistor T3 includes a third gate electrode G3 and a third active layer ACT3. In embodiments of the present disclosure, the gate electrode layer may be located in a stack on a side of the active layer away from the base substrate.

It should be noted that herein, a first electrode of the transistor may refer to one of the source electrode and the drain electrode of the transistor, and a second electrode of the transistor may refer to the other of the source electrode and drain electrode of the transistor.

The gate electrode G2 of the sensing transistor T2 is connected to a second scanning signal line GL2, the first electrode of the sensing transistor T2 is connected to a sensing signal line SL, and the second electrode of the sensing transistor T2 is electrically connected to a node SN.

The gate electrode of the driving transistor T3 is electrically connected to a node GN, the first electrode of the driving transistor T3 is connected to a first power signal (such as a high voltage level signal VDD of a driving voltage signal line), and the second electrode of the driving transistor T3 may be connected to an anode of the light emitting element, so that a driving current may be generated according to the a voltage signal to drive the light emitting element to emit light. For example, the light emitting element may be an organic light emitting diode (OLED).

Two ends of the storage capacitance Cst are respectively connected to the gate electrode and the second electrode of the driving transistor T3 so as to store the voltage signal. For example, one end of the storage capacitance Cst is electrically connected to the node GN, and the other end of the storage capacitance Cst is electrically connected to the node SN. That is, one end of the storage capacitance Cst, the second electrode of the switching transistor T1 and the gate electrode of the driving transistor T3 are connected to the node GN, and the other end of the storage capacitance Cst, the second electrode of the driving transistor T3 and the anode of the light emitting element are connected to the node SN.

As shown in FIG. 3, each pixel unit has four sub-pixels, and the pixel driving circuit of each sub-pixel includes the switching transistor T1, the sensing transistor T2, the driving transistor T3 and the storage capacitance Cst.

The gate electrode of the switching transistor T1 is connected to the first scanning signal GL1, the gate electrode of the sensing transistor T2 is connected to the second scanning signal GL2, and the gate electrode of the driving transistor T3 is connected to the second electrode of the switching transistor T1.

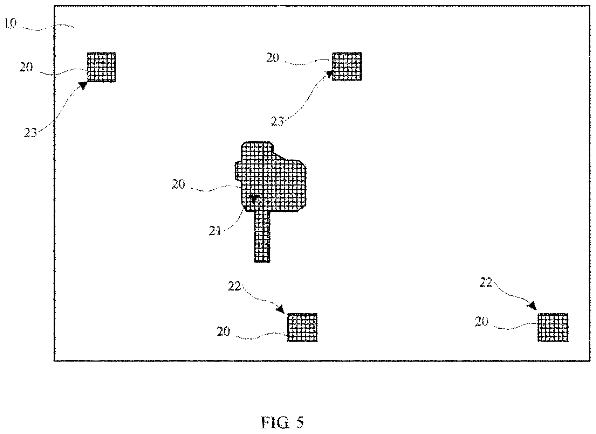

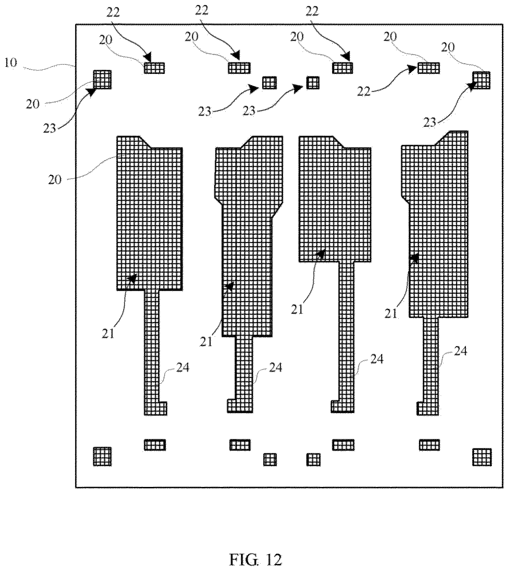

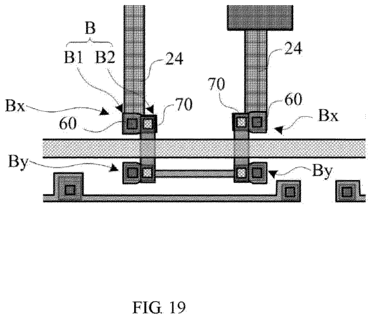

FIG. 5 to FIG. 11 are plan views of different film layers of the pixel driving circuit shown in FIG. 2A, respectively. FIG. 12 to FIG. 18 are plan views of different film layers of the pixel driving circuit shown in FIG. 3, respectively. FIG. 19 is a partial enlarged view of a sensing transistor of a display substrate according to some other embodiments of the present disclosure.

A structure of the display substrate of the present disclosure will be described in detail below in combination with FIG. 2A, FIG. 2B, FIG. 5 to FIG. 11, FIG. 3, FIG. 12 to FIG. 18 and FIG. 19. As shown in FIG. 2B, the display substrate 100 may include a base substrate 10, a functional layer 20, a light-shielding layer 30, a buffer layer 34, an active layer 40, a gate electrode layer 50, an interlayer dielectric layer 51 and other stacked structures that are arranged in sequence.

First, the structure of the display substrate of the present disclosure is introduced in general, and then the structure of the display substrate of the present disclosure is described in detail in combination with the specific drawings.

As shown in FIG. 2B, the display substrate 100 of the present disclosure includes the base substrate 10, the functional layer 20, the light-shielding layer 30, the buffer layer 34, the active layer 40, the gate electrode layer 50, the interlayer dielectric layer 51, and a first via hole 60. In addition, the display substrate further includes an existing insulating layer 80, a color film layer 110 at least the insulating layer, a resin insulating layer 120 covering the color film layer, and an electrode 90 penetrating the resin insulating layer 120 and electrically connected to a conductive layer 61.

Specifically, as shown in FIG. 2A, FIG. 2B and FIG. 3, the base substrate 120 is provided with a plurality of pixel units arranged in an array. Each pixel unit includes a plurality of sub-pixels (for example, four sub-pixels), and each sub-pixel includes a light emitting element and a pixel driving circuit for driving the light emitting element. A structure of the pixel driving circuit is shown in FIG. 4, which has already been described above, and will not be repeated here. The display substrate 100 is provided with a functional layer 20 on a side of the base substrate 10.

A light-shielding layer 30 is arranged on a side of the functional layer 20 away from the base substrate 10. The light-shielding layer 30 is electrically connected to the functional layer 20. In embodiments of the present disclosure, one part of the formed light-shielding layer 30 is used to shield light, and the other part the formed light-shielding layer 30 is used as a conductive material to transmit an electrical signal. A buffer layer 34 is arranged on a side of the light-shielding layer 30 away from the base substrate 10, and the buffer layer 34 covers the functional layer 20 and the light-shielding layer 30. An active layer 40 is arranged on a side of the buffer layer 34 away from the base substrate. The active layer is partially conducted to serve as the first or second electrode of the switching transistor T1, the first or second electrode of the sensing transistor T2, the first or second electrode of the driving transistor T3, and one of capacitance electrodes of the storage capacitance Cst, such as a second electrode of the storage capacitance Cst. A gate electrode layer 50 is arranged on a side of the active layer 40 away from the base substrate, and a gate insulating layer 42 is arranged between the active layer 40 and the gate electrode layer 50. The gate electrode layer 50 includes the first gate electrode G1 of the switching transistor T1, the second gate electrode G2 of the sensing transistor T2 and the third gate electrode G3 of the driving transistor T3. An interlayer dielectric layer 51 is arranged on a side of the gate electrode layer 50 away from the base substrate 10. The interlayer dielectric layer covers the active layer 40 and the gate electrode layer 50. The display substrate is further provided with a first via hole 60 penetrating the interlayer dielectric layer 51 and the buffer layer 34. Since the first via hole 60 penetrates the interlayer dielectric layer and the buffer layer, and thicknesses and materials of different film layers are different, a synchronous etching speed may not be effectively guaranteed when forming the first via hole 60. Therefore, in a process of forming the via hole, the functional layer 20 is arranged on a side of the first via hole 60 close to the base substrate to prevent a problem of excessive etching caused by a formation of the first via hole 60. The display substrate further includes a second via hole 70 penetrating the interlayer dielectric layer 51.

In embodiments of the present disclosure, the display substrate 100 is provided with a sensing signal line SL on a side of the interlayer dielectric layer 51 away from the base substrate, and the sensing signal line SL is used to connect with one electrode of the sensing transistor. Specifically, the functional layer 20 of the pixel driving circuit of each sub-pixel of each pixel unit is electrically connected to the sensing signal line SL at least through the first via hole 60. A projection of the light-shielding layer 30 on the base substrate 10 and a projection of the functional layer 20 on the base substrate 10 form an overlap region, and a projection of the first via hole 60 on the base substrate 10 is located in the overlap region.

According to embodiments of the present disclosure, the function layer 20 is arranged to prevent the problem of excessive etching caused by the formation of the first via hole 60. For example, the function layer is arranged on a side of the light-shielding layer close to the base substrate to prevent problems of unstable connection and abnormal electrical signal transmission caused by a penetration of the light-shielding layer due to excessive etching during an etching process. On the other hand, the display substrate of the present disclosure may effectively improve a production yield of the display substrate and save a manufacturing cost by providing the functional layer without increasing a manufacturing process.

In embodiments of the present disclosure, a thickness of the light-shielding layer 30 is greater than a thickness of the functional layer 20. The light-shielding layer 30 has functions of light-shielding and conductivity. The light-shielding layer 30 includes a first light-shielding part located in a region where the storage capacitance Cst is located, and a first conductive connection part partially located in a region where the sensing transistor T2 is located and electrically connected to the first electrode or second electrode of the sensing transistor, and a second conductive connection part for an electrical connection with the first electrode or second electrode of the driving transistor T3, the details of which will be described in detail below

In embodiments of the present disclosure, the thickness of the light-shielding layer 30 ranges from 1000 Å to 1500 Å, For example, the thickness of the light-shielding layer 30 may range from 1000 Å to 1300 Å. The thickness of the functional layer ranges from 400 Å to 1000 Å. For example, the thickness of the functional layer may range from 400 Å to 700 Å. In embodiments of the present disclosure, a light-shielding effect may be better achieved by setting the thickness of the light-shielding layer 30 to be greater than the thickness of the functional layer 20. At the same time, the thickness of the functional layer is thinner than the thickness of the light-shielding layer, so that in a process of manufacturing the display substrate, a layer of functional layer 20 may be formed while ensuring a light-shielding effect of the light-shielding layer within a limited range of film thickness, so as to achieve the technical effect of preventing excessive etching.

In embodiments of the present disclosure, an etching rate of the etching medium on the functional layer is less than an etching rate of the etching medium on the light-shielding layer. When forming the first via hole 60, the interlayer dielectric layer 51 and the buffer layer 34 need to be etched. Since an overall thickness of the interlayer dielectric layer 51 and the buffer layer 34 is relatively thick, when etching is performed, in order to save a manufacturing process and a manufacturing cost, the first via hole penetrating the interlayer dielectric layer and the buffer layer need to be etched together with other via holes (such as the second via hole 70) only penetrating the interlayer dielectric layer, thus saving time and reducing the manufacturing process.

In embodiments of the present disclosure, exemplarily, each display substrate includes a plurality of pixel units, each pixel unit may include four sub-pixels, and the pixel driving circuit of each sub-pixel at least includes the sensing transistor T2. The first electrodes or the second electrodes of all sensing transistors T2 of each pixel unit are electrically connected to the sensing signal line SL at least through the first via hole 60.

In embodiments of the present disclosure, the pixel driving circuit of the sub-pixel of each pixel unit further includes the storage capacitance Cst. A part of the functional layer forms a first electrode of the storage capacitance, and a part of the active layer forms a second electrode of the storage capacitance. The display substrate includes a first light-shielding part located in the light-shielding layer, an orthographic projection of the first electrode on the base substrate and an orthographic projection of the first light-shielding part on the base substrate overlap to form a first overlap region, and an area of the orthographic projection of the first electrode on the base substrate is greater than an area of the orthographic projection of the first light-shielding part on the base substrate. The first electrode is electrically connected to the first electrode or the second electrode of the sensing transistor through the first via hole, and the orthographic projection of the first via hole on the base substrate is located in the first overlap region.

In embodiments of the present disclosure, a part of the functional layer forms a first functional region of the sensing transistor T2. An orthographic projection of the light-shielding layer on the base substrate overlaps with an orthographic projection of the first functional region on the base substrate to form a second overlap region. The orthographic projection of the first via hole on the base substrate is located in the second overlap region. The first electrode or the second electrode of the sensing transistor is electrically connected to the first functional region through the first via hole. A part of the light-shielding layer forms a first conductive connection part, and the first conductive connection part is used to electrically connect first functional regions of the sensing transistors of different sub-pixels. Such part of the light-shielding layer is used for transmitting the electrical signal. As a conductive connection part, the light-shielding layer may achieve a signal transmission while reducing the manufacturing process of the base substrate.

In embodiments of the present disclosure, the pixel driving circuit of each sub-pixel at least includes the driving transistor. The first electrode or the second electrode of each driving transistor is electrically connected to the first electrode through the first via hole.

In embodiments of the present disclosure, the display substrate further includes a driving voltage signal line VDD arranged on a side of the interlayer dielectric layer away from the base substrate, and the driving voltage signal line VDD is electrically connected to the first electrode or the second electrode of the driving transistor T3. In addition, a part of the functional layer forms the functional region of the driving transistor T3, and a part of the light-shielding layer forms a second conductive connection part. The second conductive connection part is used to electrically connect the second functional region of at least one sub-pixel in one and the same pixel unit with the driving voltage signal line.

In addition, an orthographic projection of the second functional region on the base substrate and an orthographic projection of the second conductive connection part on the base substrate coincide to form a third overlap region, and the orthographic projection of the first via hole on the base substrate is located in the third overlap region.

In embodiments of the present disclosure, the light-shielding layer includes an opaque metal conductive material, such as silver, aluminum and other conductive metal materials, which is not limited in embodiments of the present application.

The functional layer includes a light-transmitting metal oxide material, including indium gallium zinc oxide (IGZO), which is not limited in embodiments of the present application.

Specific structures of each film layer of the display substrate of the present disclosure will be described in detail below in combination with FIG. 5 to FIG. 11 and FIG. 12 to FIG. 18.

FIG. 5 to FIG. 11 are plan views of different film layers of a pixel driving circuit of a sub-pixel shown in FIG. 2A, respectively. FIG. 12 to FIG. 18 are plan views of different film layers of a pixel driving circuit of each sub-pixel in a pixel unit shown in FIG. 3.

As shown in FIG. 5 and FIG. 12, the functional layer 20 is formed on a side of the base substrate 10. The functional layer 20 has a shape as shown in FIG. 5 and FIG. 12. In the embodiment, a shape and a position of the functional layer 20 in a region where the pixel driving circuit of the sub-pixel is located are only schematically shown. In a process of forming the functional layer 20, an array structure of the shape in the drawing may be formed.

In FIG. 5 and FIG. 12, a part of the functional layer 20 forms the first electrode 21 of the storage capacitance Cst, another part of the functional layer 20 forms the first functional region 22 of the sensing transistor, and yet another part of the functional layer 20 further forms the second functional region 23.

As shown in FIG. 12, a structure diagram of a functional layer 20 of a pixel unit formed on the base substrate 10 is shown. A pixel unit includes, for example, four sub-pixels, and the functional layer 20 is formed on positions of each sub-pixel. The functional layer with a larger area in each sub-pixel formed in FIG. 12 is the first electrode 21 of the storage capacitance, and the first functional region 22 and the second functional region 23 formed by a part of the functional layer 20 are respectively located on upper and lower sides of the first electrode 21.

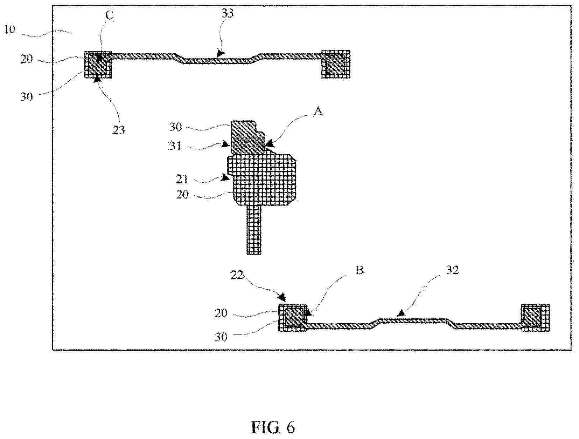

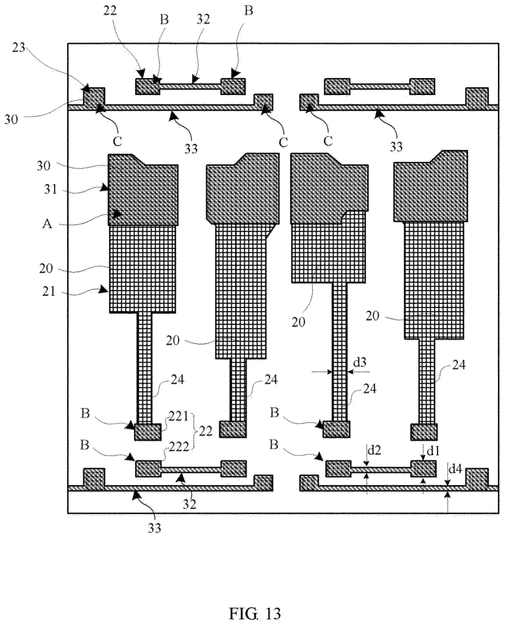

As shown in FIG. 6 and FIG. 13, after the functional layer 20 is formed, the light-shielding layer 30 is formed on a side of the functional layer 20 away from the base substrate, and a part of the light-shielding layer 30 forms the first light-shielding part 31. There is an overlap region between the first electrode 21 and the first light-shielding part 31. For example, the orthographic projection of the first electrode 21 on the base substrate 10 overlaps with the orthographic projection of the first light-shielding part 31 on the base substrate 10 to form the first overlap region A.

An orthographic projection of a part of the light-shielding layer 30 on the base substrate 10 overlaps with the orthographic projection of the first functional region 22 on the base substrate 10 to form the second overlap region B.

An orthographic projection of a part of the light-shielding layer 30 on the base substrate 10 overlaps with the orthographic projection of the second functional region 23 on the base substrate 10 to form the third overlap region C. In embodiments of the present disclosure, the overlap may mean a partial overlap or a complete overlap.

As shown in FIG. 13, a pixel unit includes four different sub-pixels. After the functional layer 20 is formed, the light-shielding layer 30 is formed on a side of the functional layer 20 away from the base substrate. In FIG. 13, a part close to an upper side of the first electrode 21 of the storage capacitance of the sub-pixel is the light-shielding layer 30. the first overlap region A is formed between the first light-shielding part 31 of the light-shielding layer and the first electrode 21. In addition, a part of the light-shielding layer 30 further forms the second overlap region B with the first functional region 22, and a part of the light-shielding layer further forms the third overlap region C with the second functional region 23. In embodiments of the present disclosure, as shown in FIG. 6 and FIG. 13, the area of the orthographic projection of the first electrode 21 on the base substrate is greater than the area of the orthographic projection of the first light-shielding part 31 on the base substrate.

In embodiments of the present disclosure, a part of the light-shielding layer 30 further forms the first conductive connection part 32 and the second conductive connection part 33. As shown in FIG. 13, the first conductive connection part 32 electrically connects the first functional regions 22 of the sensing transistors of different sub-pixels, such as the first functional regions 22 of two adjacent sub-pixels on the same side of the sensing signal line SL. The second conductive connection part 33 is used to electrically connect the second functional region 23 of at least one sub-pixel in one and the same pixel unit with the driving voltage signal line VDD. For example, the second conductive connection part 33 electrically connects the second functional region 23 of the sub-pixel located on a side away from the driving voltage signal line VDD with the driving voltage signal line VDD.

In embodiments of the present disclosure, in a direction perpendicular to a length of the first conductive connection part, a width of the first conductive connection part located in the second overlap region B is greater than a width of the first conductive connection part between adjacent sub-pixels.

As shown in FIG. 13, in the direction perpendicular to the length of the first conductive connection part 32, the first conductive connection part located in the second overlap region B has a width d1, and the first conductive connection part 32 between adjacent sub-pixels has a width d2, where d1 is greater than d2. According to the embodiment, the width of the conductive connection part in the second overlap region B is greater than the width thereof between adjacent sub-pixels, so that a contact area between the first conductive connection part 32 and the first functional region is increased, and a good electrical connection may be ensured.

In embodiments of the present disclosure, the first functional region includes a first functional sub-region and a second functional sub-region. The first functional sub-region is electrically connected to the first electrode, and the first conductive connection part 32 is used to electrically connect the second functional sub-regions of the sensing transistors between different sub-pixels.

As shown in FIG. 13, the first functional region 22 includes the first functional sub-region 221 located at the first electrode (such as the source electrode) of the sensing transistor and the second functional sub-region 222 located at the second electrode (such as the drain electrode) of the sensing transistor. The first functional sub-region 221 is electrically connected to the first electrode 21 of the storage capacitance Cst, and the second functional sub-region 222 is electrically connected to the first conductive connection part 32. Specifically, the first conductive connection part 32 electrically connects the second functional sub-regions 222 of the sensing transistors of different sub-pixels.

In embodiments of the present disclosure, as shown in FIG. 12 and FIG. 13, a part of the functional layer 20 forms a third conductive connection part 24 for electrically connecting the first electrode 21 with the first functional sub-region 221 of the sensing transistor. A width d3 of the third conductive connection part 24 in a length direction of the third conductive connection part is greater than the width d2 of the first conductive connection part in the length direction of the first conductive connection part, and/or greater than a width d4 of the second conductive connection part in a length direction of the second conductive connection part. According to embodiments of the present disclosure, the functional region reduces a resistance and improves a conductive connection performance by increasing the width of the third conductive connection part 24.

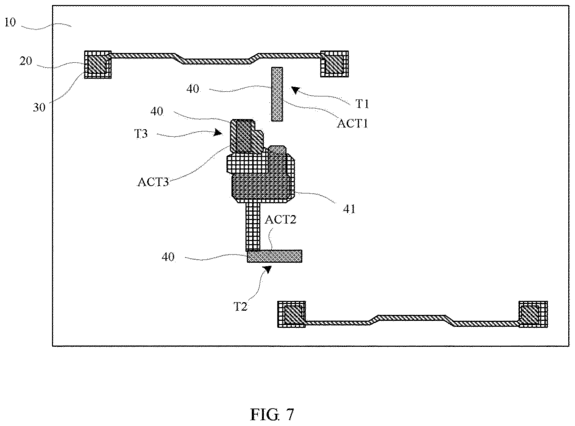

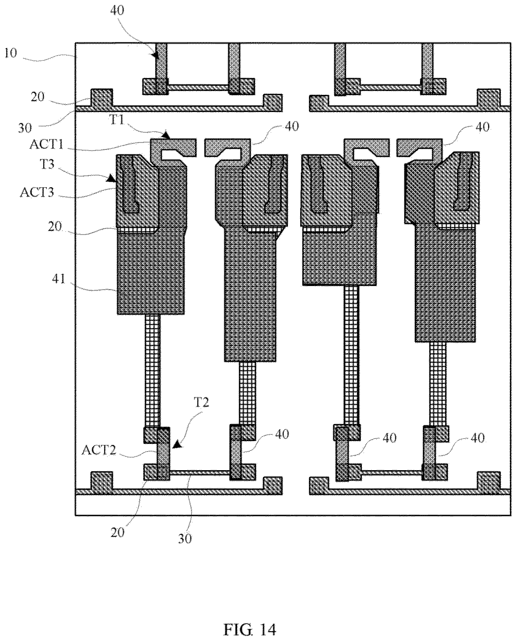

As shown in FIG. 7 and FIG. 14, the active layer 40 is arranged on a side of the light-shielding layer 30 away from the base substrate 10. In order to explain the display substrate of embodiments of the present disclosure more clearly, the buffer layer formed on a side of the light-shielding layer 30 away from the base substrate 10 and covering the functional layer 20 and the light-shielding layer 30 is not marked in a plan structure of the film layer. In a sectional view, the buffer layer 34 covers the functional layer 20 and the light-shielding layer 30. In the embodiment, the formed active layer 40 includes the second electrode 41 of the storage capacitance formed at a location of the storage capacitance Cst. A part of the active layer 40 is formed as the first active layer ACT1 of the switching transistor T1. A part of the active layer 40 is formed as the second active layer ACT2 of the sensing transistor T2. A part of the active layer 40 is formed as the third active layer ACT3 of the driving transistor T3.

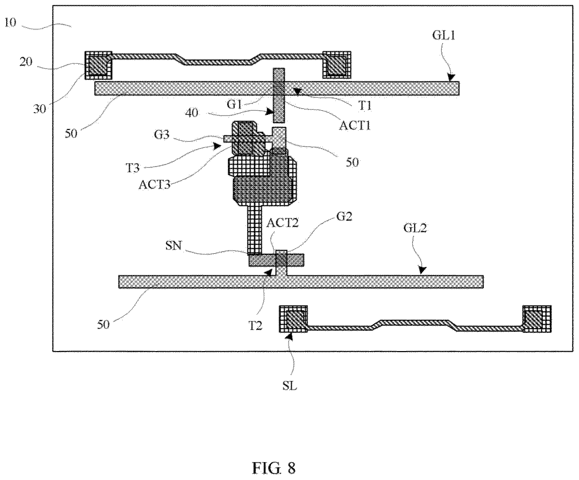

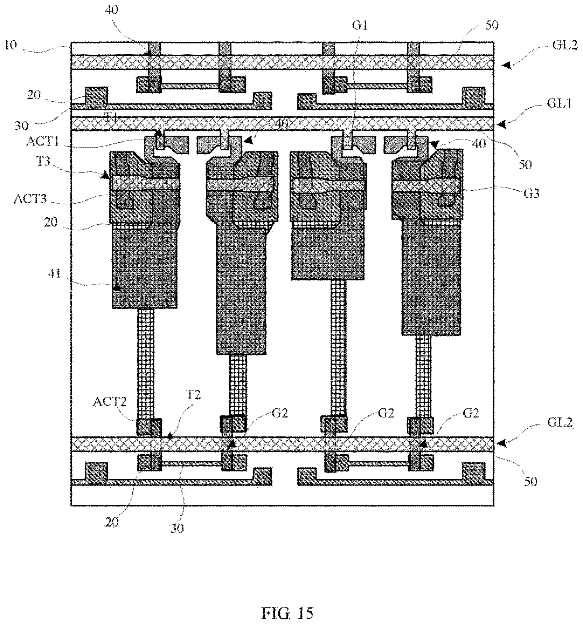

As shown in FIG. 8 and FIG. 15, after the active layer 40 is formed, the gate electrode layer 50 is formed on a side of the active layer 40 away from the base substrate 10. A part of the gate electrode layer connected to the first scanning signal GL1 forms the gate electrode G1 of the switching transistor T1, and a part of the gate electrode layer electrically connected to the second scanning signal GL2 forms the gate electrode G2 of the sensing transistor T2. The gate electrode layer connected to one electrode of the active layer ACT1 of the switching transistor T1 forms the gate electrode G3 of the driving transistor T3.

After the gate electrode layer 50 is formed, the interlayer dielectric layer 51 is arranged on a side of the gate electrode layer 50 away from the base substrate, and the interlayer dielectric layer 51 covers the active layer 40 and the gate electrode layer 50. FIG. 8 and FIG. 15 of embodiments of the present disclosure do not mark the interlayer dielectric layer. A stacking relationship between the interlayer dielectric layer 51 and the gate electrode layer 50 is shown in FIG. 2B. The interlayer dielectric layer 51 covers the active layer 40 and the gate electrode layer 50.

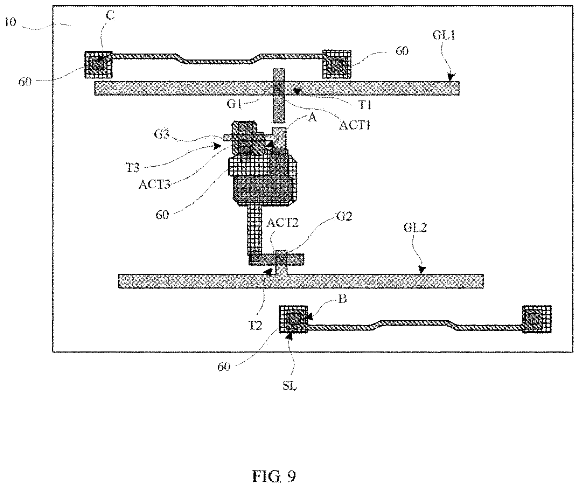

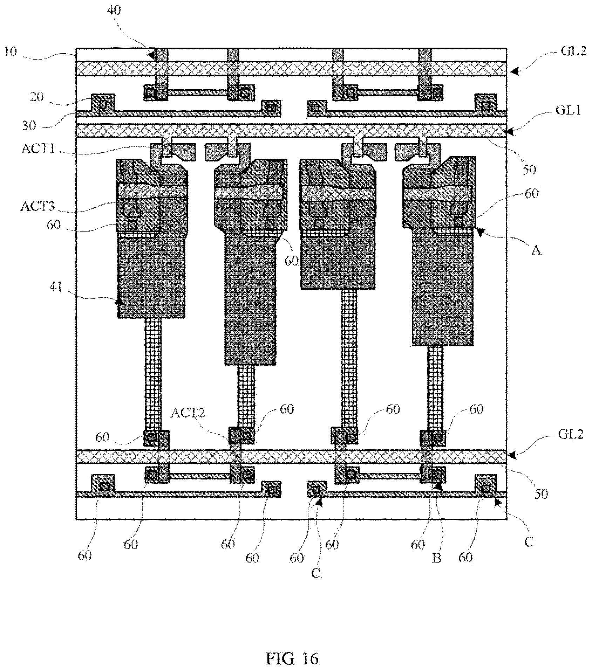

After the interlayer dielectric layer 51 is formed, the first via hole 60 penetrating the interlayer dielectric layer 51 and the buffer layer 34 is formed next. As shown in FIG. 9 and FIG. 16. The first via holes 60 are formed in the first overlap region A, the second overlap region B and the third overlap region C, respectively. In the first overlap region A, an orthographic projection of the first via hole 60 on the base substrate at least partially coincides with the first overlap region A. In the second overlap region B, an orthographic projection of the first via hole 60 on the base substrate at least partially coincides with the second overlap region B. In the third overlap region C, an orthographic projection of the first via hole 60 on the base substrate at least partially coincides with the third overlap region.

In embodiments of the present disclosure, in the second overlap region B and the third overlap region C, the orthographic projection of the functional layer on the base substrate is located within the orthographic projection of the light-shielding layer on the base substrate. For example, a part of the light-shielding layer 30 and the first functional region 22 form the second overlap region B, and another part of the light-shielding layer and the second functional region 23 form the third overlap region C, that is, the light-shielding layer may completely cover the functional layer in the second overlap region B and the third overlap region C, or a size of the light-shielding layer is the same as a size of the functional layer, thus ensuring that the light-shielding layer in the second overlap region and the third overlap region has a good electrical connection relationship with the functional layer.

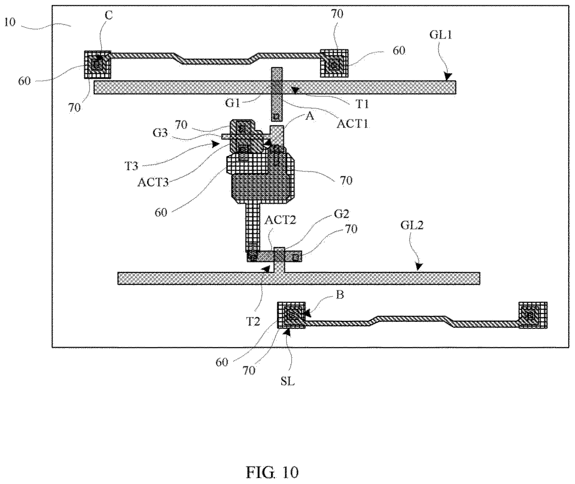

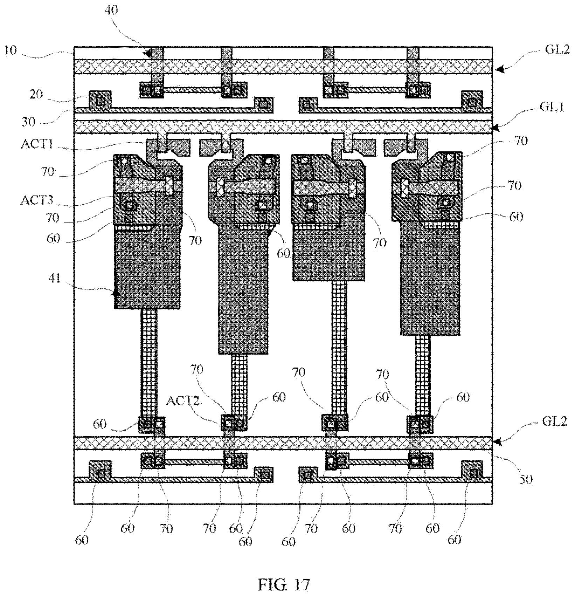

As shown in FIG. 10 and FIG. 17, the first via hole 60 and the second via hole 70, such as the via hole 70 penetrating the interlayer dielectric layer 51, are formed. The second via hole 70 is formed to electrically connect the active layer of the transistor (such as the first electrode or the second electrode) with the driving voltage signal line VDD, the sensing signal line SL, the first scanning signal line GL1, the second scanning signal line GL2, the data line DL, etc.

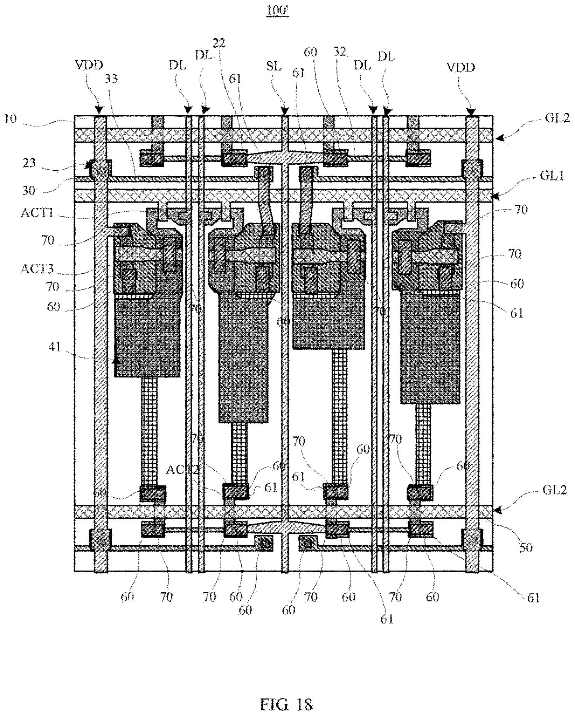

After the second via hole 70 is formed, as shown in FIG. 2B, FIG. 11 and FIG. 18, it is continued to form the conductive layer 61 on a side of the interlayer dielectric layer 51 away from the base substrate. For example, the conductive layer 61 passes the first via hole 60 and the second via hole 70 and is used to transmit various electrical signals through. For example, as shown in FIG. 18, the sensing signal line SL is formed at a middle position of each pixel unit, and the sensing signal line SL is electrically connected to the first conductive connection part 32 through the first via hole 60. Two ends of each sensing signal line are respectively provided with two adjacent sub-pixels, and the first conductive connection part 32 electrically connects the first functional regions 22 of the two adjacent sub-pixels on the same side of the sensing signal line SL. Two data lines DL are provided between the same two adjacent sub-pixels of the same sensing signal line SL, and each data line DL is electrically connected to the first electrode or the second electrode of the switching transistor T1. In the embodiment, the driving voltage signal line VDD connects the second functional region 23 of the sub-pixel located on a side away from the driving voltage signal line VDD with the driving voltage signal line through the second conductive connection part 33.

FIG. 2B is a sectional view taken along line MM' in FIG. 2A.

As shown in FIG. 2B, the display substrate of the present disclosure includes the base substrate 10, the functional layer 20 arranged on the base substrate 10, and the light-shielding layer 30 on a side of the functional layer 20 away from the base substrate. The functional layer 20 and the light-shielding layer 30 are electrically connected to ensure the transmission of electrical signals. The buffer layer 34 is arranged on a side of the light-shielding layer 30 away from the base substrate. In the embodiment, a material of the buffer layer 34 may be an insulating oxide, nitride, nitrogen oxide, or the like.

The active layer 40 is arranged on a side of the buffer layer 34 away from the base substrate, and the active layer 40 forms the source electrode or the drain electrode of the transistor. A material of the active layer may be a metal oxide semiconductor, such as IGZO, zinc oxide ZnO or zinc oxynitride ZnON, etc. IGZO has better performance and is more widely applied. The material of the active layer may also be monocrystalline silicon, polycrystalline silicon, etc., which is not limited here, and is determined according to actual requirements.

After the active layer 40 is formed, the gate electrode insulating layer 42 is formed on the active layer. The gate electrode layer 50 is formed on a side of the gate insulating layer 42 away from the base substrate. The interlayer dielectric layer 51 is formed on a side of the gate electrode layer 50 away from the base substrate. The interlayer dielectric layer is used to cover the gate electrode layer 50 and the active layer 40.

The display substrate of the present disclosure further has the first via hole 60 penetrating the interlayer dielectric layer 51 and the buffer layer 34, and the second via hole 70 only penetrating the interlayer dielectric layer 51. The conductive layer 61 is arranged on the interlayer dielectric layer 51, and the conductive layer 61 is electrically connected to other structures through the via hole, for example, electrically connect the first electrode or the second electrode of the transistor of the active layer with the functional layer and the light-shielding layer. An upper side of the conductive layer 61 is provided with an insulating layer 80, and the insulating layer 80 is located in the light emitting region and the non-light-emitting region, and at least covers the interlayer dielectric layer 51 and the conductive layer 61.

A side of the insulating layer 80 away from the base substrate is further provided with the electrode 90, such as an anode, which is electrically connected to the conductive layer 61 in the first via hole 60. In embodiments of the present disclosure, the color film layer 110 and the resin insulating layer 120 (such as a Resin layer) covering the color film layer are sequentially formed on the insulating layer 80.

FIG. 19 is a partial enlarged view of a sensing transistor of a display substrate according to some other embodiments of the present disclosure.

As shown in FIG. 19, the second overlap region B includes a first overlap sub-region B1 and a second overlap sub-region B2. An area of the first overlap sub-region B1 is greater than an area of the second overlap sub-region B2. The orthogonal projection of the first via hole 60 on the base substrate is located in the first overlap sub-region B 1. According to embodiments of the present disclosure, by setting the area of the first overlap sub-region B1 to be greater than the area of the second overlap sub-region B2, a defect generation during the formation of the first via hole may be reduced in a process of forming the first via hole 60.

In the embodiment, the second overlap region includes a first electrode overlap region at the first electrode of the sensing transistor and a second electrode overlap region at the second electrode of the sensing transistor. The first electrode overlap region and the second electrode overlap region in one and the same sensing transistor have a proportionally same shape.

For example, as shown in FIG. 19, the second overlap region B includes a first electrode overlap region Bx at the first electrode of the sensing transistor and a second electrode overlap region By at the second electrode of the sensing transistor. The first electrode overlap region Bx and the second electrode overlap region By in one and the same sensing transistor have a proportionally same shape, which may be that the first polar overlap region Bx and the second polar overlap region By have the same shape (i.e., the same contour and orientation, facing the same direction), and different sizes.

In other alternative embodiments, the shape and orientation of the first electrode overlap region Bx and the second electrode overlap region By may be different, and may be set according to actual requirements.

The structure of the display substrate of embodiments of the present disclosure is exemplarily illustrated above to facilitate those skilled in the art to understand the contents of the present disclosure.

According to embodiments of the present disclosure, the function layer is arranged to prevent the problem of excessive etching caused by the formation of the first via hole. Specifically, the function layer is arranged on a side of the light-shielding layer close to the base substrate to prevent problems of unstable connection and abnormal signal transmission caused by the penetration of the light-shielding layer due to excessive etching during the etching process. On the other hand, the display substrate of the present disclosure may effectively improve the production yield of the display substrate and save the manufacturing cost by providing the functional layer without increasing the manufacturing process.

A second aspect of the present disclosure provides a method of manufacturing a display substrate. During an etching process of the first via hole, the display substrate manufactured by the method may effectively improve a resistance to etching at a position of the first via hole, preventing problems of excessive etching due to excessive etching time, unstable electrical signal transmission caused by excessive etching of the display substrate, and the low yield of the display substrate, and effectively improving the yield and the display quality of the display substrate.

The method of the present disclosure specifically includes operation S1 to operation S9.

In operation S1, a substrate is formed; optionally, the base substrate may be a rigid substrate or a flexible substrate; the rigid substrate may be, but not limited to, one or more of glass and metal foil; the flexible substrate may be, but not limited to, one or more of polyethylene terephthalate, polystyrene, polyethylene, textile fiber, polyimide and polyvinyl chloride.

After the base substrate is formed, a plurality of pixel units are formed on the base substrate, and the pixel units are formed on the base substrate. Forming a plurality of pixel units includes forming a plurality of sub-pixels in each pixel unit, forming a light emitting element and forming a pixel driving circuit for driving the light emitting element at each sub-pixel.

Specifically, the forming a pixel driving circuit after operation S 1 includes operation S2 to operation S9.

In operation S2, a functional layer is formed on a side of the base substrate. The functional layer may be, for example, a metal or a metal oxide (such as ITO). In embodiments of the present disclosure, the functional layer is used to block the etching medium on one hand, and to transmit the electrical signal on the other hand.

For example, a functional layer may be formed on the base substrate by a patterning process.

Next, operation S3 is performed after operation S2.

In operation S3, a light-shielding layer is formed on a side of the functional layer away from the base substrate, and the light-shielding layer is electrically connected to the functional layer. In embodiments of the present disclosure, a part of the light-shielding layer is used to shield light, and another part of the light-shielding layer is used to transmit the electrical signal.

For example, a part of the formed light-shielding layer includes a first conductive connection part, and the first conductive connection part is used to electrically connect the first functional regions of the sensing transistors of different sub-pixels.

For another example, a part of the formed light-shielding layer includes a second conductive connection part, and the second conductive connection part is used to electrically connect the second functional region of at least one sub-pixel in one and the same pixel unit with the driving voltage signal line.

Operation S4 is performed after operation S3.

In operation S4, a buffer layer is formed on a side of the light-shielding layer away from the base substrate, and the buffer layer covers the functional layer and the light-shielding layer. For example, a material of the buffer layer may be an insulating oxide, nitride or oxynitride compound.

Operation S5 is performed after operation S4.

In operation S5, an active layer is formed on a side of the buffer layer away from the base substrate, and a gate electrode layer is formed next on a side of the active layer away from the base substrate.

For example, a material of the gate electrode layer may be a metal or a metal alloy, such as Cu, Al, Ag, Mo, Cr, Nd, Ni, Mn, Ti, Ta, W and other metals, and alloys thereof.

After the gate electrode layer is formed, operation S6 is performed to form an interlayer dielectric layer on a side of the gate electrode layer away from the base substrate, and the interlayer dielectric layer covers the active layer and the gate electrode layer. In other alternative embodiments, the interlayer dielectric layer may not be formed.

In the embodiment, after the interlayer dielectric layer is formed, operation S7 is performed to form a first via hole, and the first via hole penetrates the interlayer dielectric layer and the buffer layer. In other alternative embodiments, when the interlayer dielectric layer is not formed, the first via hole penetrates the buffer layer.

For example, a formation of the first via hole may be completed by an etching process. During the etching process of the first via hole, due to differences in thicknesses and material characteristics of the interlayer dielectric layer and the buffer layer, and due to influences of an etching time and other processes during the etching process, if a process design is not reasonable, it is easy to cause a material on a lower side of the first via hole to be excessively etched, seriously affecting the overlap and the transmission of the electrical signal, and the production yield is easily reduced. The present disclosure effectively prevents the problem that a material at the first via hole is excessively etched during the formation of the first via hole by providing the functional layer on the base substrate, thereby improving the production yield of the display substrate. Meanwhile, the manufacturing method of the present disclosure may solve the above-mentioned problems without increasing the manufacturing process and manufacturing time.

In embodiments of the present disclosure, in the process of forming the first via hole, the second via may be formed simultaneously to reduce the manufacturing process of the display substrate and improve an efficiency.

After the first via hole is formed, operation S8 is performed to form a conductive layer on a side of the interlayer dielectric layer away from the base substrate, such as the driving voltage signal line VDD, the sensing signal line SL, the first scanning signal line GL1, the second scanning signal line GL2, the data line DL and other signal lines.

Operation S9 is performed after the conductive layer is formed. In operation S9, an insulating layer such as a PVX insulating layer is formed. An anode is formed on the insulating layer, and the anode is located in the light emitting region and the non-light-emitting region.

It should be noted that if the OLED light emitting unit of the above-mentioned display substrate adopts a WOLED structure (i.e., the light emitted by each OLED light emitting unit is white), after the formation of the insulating layer and before the formation of the anode on the insulating layer, the above-mentioned method of manufacturing the display substrate further includes: sequentially forming a color film layer and a resin insulating layer (Resin layer) covering the color film layer on the insulating layer.

In embodiments of the present disclosure, a thickness of the formed light-shielding layer is greater than a thickness of the formed functional layer. Furthermore, the thickness of the formed light-shielding layer ranges from 1000 Å to 1500 Å. The thickness of the formed functional layer ranges from 400 Å to 1000 Å. Thus, in a limited thickness range, the formed light-shielding layer and the formed functional layer may not only achieve the light-shielding effect of the light-shielding layer, but also prevent the problem of excessive etching caused by etching and ensure the yield of the manufactured display substrate. According to embodiments of the present disclosure, an etching rate of the etching medium on the functional layer is less than an etching rate of the etching medium on the light-shielding layer.

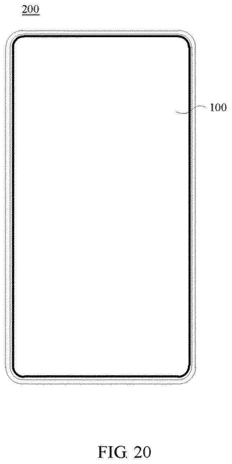

In some embodiments of the present disclosure, as shown in FIG. 20, embodiments of the present disclosure further provide a display device 200, and the display device may include the above-mentioned display substrate 100. The display device may include but is not limited to: an electronic paper, a mobile phone, a tablet computer, a television, a monitor, a laptop, a digital photo frame, a navigator and any product or component with display function. It should be understood that the display device has the same beneficial effect as the display substrate provided in the preceding embodiments.

Although some embodiments of the general technical concept of the present disclosure have been illustrated and described, those of ordinary skill in the art will appreciate that these embodiments may be changed without departing from the principle and spirit of the general technical concept of the present disclosure. The scope of the present disclosure is defined by the claims and their equivalents.

## Claims

1. A display substrate, comprising:
a base substrate and a plurality of pixel units arranged on the base substrate, wherein each pixel unit comprises a plurality of sub-pixels, and each sub-pixel comprises a light emitting element and a pixel driving circuit for driving the light emitting element;
wherein the pixel driving circuit comprises:
a functional layer arranged on a side of the base substrate;
a light-shielding layer arranged on a side of the functional layer away from the base substrate, wherein the light-shielding layer is electrically connected to the functional layer;
a buffer layer arranged on a side of the light-shielding layer away from the base substrate and covering the functional layer and the light-shielding layer;
an active layer arranged on a side of the buffer layer away from the base substrate;
a gate electrode layer arranged on a side of the active layer away from the base substrate;
a first via hole penetrating the buffer layer; and
a signal line arranged on a side of the buffer layer away from the base substrate;
wherein the functional layer of the pixel driving circuit of each sub-pixel is electrically connected to the signal line at least through the first via hole; and
wherein a projection of the light-shielding layer on the base substrate and a projection of the functional layer on the base substrate form an overlap region, and a projection of the first via hole on the base substrate is located in the overlap region.

2. The display substrate according to claim 1, wherein a thickness of the light-shielding layer is greater than a thickness of the functional layer.

3. The display substrate according to claim 1, wherein the pixel driving circuit comprises a storage capacitance;
wherein a part of the functional layer forms a first electrode of the storage capacitance, and a part of the active layer forms a second electrode of the storage capacitance; and
wherein the light-shielding layer comprises a first light-shielding part, an orthographic projection of the first electrode on the base substrate overlaps with an orthographic projection of the first light-shielding part on the base substrate to form a first overlap region, and an area of the orthographic projection of the first electrode on the base substrate is greater than an area of the orthographic projection of the first light-shielding part on the base substrate.

4. The display substrate according to claim 3, wherein an orthographic projection of the first via hole on the base substrate is located in the first overlap region.

5. The display substrate according to claim 3, wherein the signal line comprises a sensing signal line, and the pixel driving circuit of each sub-pixel at least comprises a sensing transistor;
wherein first electrodes or second electrodes of all sensing transistors of each pixel unit are electrically connected to the sensing signal line at least through the first via hole;
wherein a part of the functional layer forms a first functional region of the sensing transistor; and
wherein an orthographic projection of the light-shielding layer on the base substrate overlaps with an orthographic projection of the first functional region on the base substrate to form a second overlap region.

6. The display substrate according to claim 5, wherein the orthographic projection of the first via hole on the base substrate is located in the second overlap region.

7. The display substrate according to claim 5, wherein the first electrode or the second electrode of the sensing transistor is electrically connected to the first functional region through the first via hole.

8. The display substrate according to claim 7, wherein the first functional region comprises a first functional sub-region and a second functional sub-region; and
wherein a part of the light-shielding layer forms a first conductive connection part, the first functional sub-region is electrically connected to the first electrode, and the first conductive connection part is configured to electrically connect the second functional sub-regions of the sensing transistors of different sub-pixels.

9. The display substrate according to claim 8, wherein the pixel driving circuit of each sub-pixel further comprises a driving transistor;
wherein a first electrode or a second electrode of each driving transistor is electrically connected to the first electrode through the first via hole;
wherein the signal line further comprises a driving voltage signal line;
wherein a part of the functional layer forms a second functional region electrically connected to the first electrode or the second electrode of the driving transistor; and
wherein a part of the light-shielding layer forms a second conductive connection part, and the second conductive connection part is configured to electrically connect the second functional region of at least one sub-pixel in one and the same pixel unit with the driving voltage signal line.

10. The display substrate according to claim 9, wherein an orthographic projection of the second functional region on the base substrate and an orthographic projection of the second conductive connection part on the base substrate coincides to form a third overlap region.

11. The display substrate according to claim 10, wherein the orthographic projection of the first via hole on the base substrate is located in the third overlap region.

12. The display substrate according to claim 10, wherein in a direction perpendicular to a length of the first conductive connection part, a width of the first conductive connection part located in the second overlap region is greater than a width of the first conductive connection part between adjacent sub-pixels.

13. The display substrate according to claim 10, wherein in the second overlap region and the third overlap region, the orthographic projection of the functional layer on the base substrate is located within the orthographic projection of the light-shielding layer on the base substrate.

14. The display substrate according to claim 10, wherein a part of the functional layer forms a third conductive connection part, and the third conductive connection part is configured to electrically connect the first electrode with the first functional sub-region of the sensing transistor.

15. The display substrate according to claim 14, wherein a width of the third conductive connection part in a length direction of the third conductive connection part is greater than a width of the first conductive connection part in a length direction of the first conductive connection part.

16. The display substrate according to claim 14, wherein a width of the third conductive connection part in a length direction of the third conductive connection part is greater than a width of the second conductive connection part in a length direction of the second conductive connection part.

17. The display substrate according to claim 10, wherein the second overlap region comprises a first overlap sub-region and a second overlap sub-region, an area of the first overlap sub-region is greater than an area of the second overlap sub-region, and the orthographic projection of the first via hole on the base substrate is located in the first overlap sub-region.

18. The display substrate according to claim 17, wherein the second overlap region comprises a first electrode overlap region located at the first electrode of the sensing transistor, and a second electrode overlap region located at the second electrode of the sensing transistor; and
wherein the first electrode overlap region and the second electrode overlap region have a proportionally same shape.

19. The display substrate according to any one of claims 1 to 18, wherein the light-shielding layer comprises an opaque metal conductive material; and
wherein the functional layer comprises a light-transmitting metal oxide material.

20. A method of manufacturing a display substrate, comprising:
forming a base substrate;
forming a plurality of pixel units on the base substrate, wherein each pixel unit comprises a plurality of sub-pixels, and the forming a plurality of pixel units comprises forming, at each sub-pixel, a light emitting element and a pixel driving circuit for driving the light emitting element;
wherein the forming a pixel driving circuit comprises:
forming a functional layer on a side of the base substrate;
forming a light-shielding layer on a side of the functional layer away from the base substrate, wherein the light-shielding layer is electrically connected to the functional layer;
forming a buffer layer on a side of the light-shielding layer away from the base substrate, wherein the buffer layer covers the functional layer and the light-shielding layer;
forming an active layer on a side of the buffer layer away from the base substrate;
forming a gate electrode layer on a side of the active layer away from the base substrate;
forming a first via hole penetrating the buffer layer; and
forming a signal line on a side of the buffer layer away from the base substrate;
wherein the functional layer of the pixel driving circuit of each sub-pixel is electrically connected to the signal line at least through the first via hole; and
wherein a projection of the light-shielding layer on the base substrate and a projection of the functional layer on the base substrate form an overlap region, and a projection of the first via hole on the base substrate is located in the overlap region.

21. A display device, wherein the display device comprises the display substrate according to any one of claims 1 to 19.
